# EUROPEAN PATENT APPLICATION

(11) **EP 2 597 250 A1**
(43) Date of publication of application: **29.05.2013**
(21) Application number: 11290540.1
(22) Date of filing: 24.11.2011
(51) Int. Cl.: E21B 17/10, E21B 47/01

(54) **Longitudinal absorber for downhole tool chassis**

(71) Applicant: Services Pétroliers Schlumberger, 75007 Paris (FR); Schlumberger Technology B.V., 2514 JG The Hague (NL); Schlumberger Holdings Limited, Tortola (VG); PRAD Research and Development Limited, Road Town, Tortola (VG)
(72) Inventor: Durisotti, Sylvain, 94800 Villejuif (FR); Abgrall, Romain, 92140 Clamart (FR)
(74) Representative: Rzaniak, Martin

(57) **Abstract**

A chassis assembly is disclosed for housing at least one circuit board. The chassis has a first chassis part, a second chassis part, and at least three shock absorbers. The first chassis part has a first end and a second end, and a first external surface extending between the first end and the second end. The first chassis part also has a first longitudinal axis extending from the first end to the second end. The second chassis part has a third end and a fourth end and a second external surface extending between the third end and the fourth end. The second chassis pat has a second longitudinal axis extending from the third end to the fourth end. The first and second chassis parts are adapted to cooperate to secure the at least one circuit board within a boundary defined by the first and second external surfaces. The at least three shock absorbers are positioned on the external surfaces of the first and second chassis parts. At least one shock absorber is positioned on the first external surface and extends along the first longitudinal axis between the first end and the second end. At least two shock absorbers are positioned on the second external surface and extend along the second longitudinal axis between the third end and the fourth end. The at least three shock absorbers extend beyond the first and second external surfaces.

## Description

### TECHNICAL FIELD

This invention relates generally to shock absorbers for the housing for a downhole tool chassis (referred to herein as a "chassis") used to encapsulate a printed circuit board used in oil and gas wells or the like. More particularly, but not by way of limitation, the present invention relates to shock absorbers, longitudinally arranged on a chassis assembly for a printed circuit board, which offers enhanced resistance to amplification shock damage, allowing the chassis assembly to maintain a more rigid contact with a housing.

### BACKGROUND ART

In the oil and gas industry, subsurface formations are typically probed by well logging instruments to determine the formation characteristics. For example sonic tools have been found to provide valuable information regarding subsurface acoustic properties, which may be used to produce images or derive related characteristics for the formations.

Currently many downhole tools used in the exploration and production of hydrocarbons employ sensitive electrical processing devices referred to herein as downhole components. The downhole components include without limitation electrical devices, electrical components, electrical circuits, printed circuit boards, downhole sensors, cooling components, antennas, and/or receivers. Downhole tools also often experience high shock and vibration conditions either during use within a wellbore, or during handling after they have been assembled and prior to use within a wellbore. Often times the shock or vibration can damage the downhole components thereby rendering the component inoperable or ineffective. Further, the shock and vibration during use can cause the downhole component to provide erroneous data, this is especially so when the downhole component is a sensor monitoring data downhole for later analysis. The harsh downhole conditions introduce another environmental factor that must be considered, and that is the high temperature, which can sometimes exceed 200° C. Accordingly, any damping device or element used in a downhole application must be able to function relatively consistently at the expected range of operating temperatures.

Various attempts have been made to lessen the shock and vibration of mechanical dynamics experienced by downhole components during handling and use of downhole tools. These attempts generally involve attempting to dampen the shock and vibration applied to the downhole components with some type of an elastomer. For example, rubber O rings have been employed to isolate downhole components from shock and vibration experienced by a downhole tool. Additionally, downhole components have been seated within the downhole tools on visco-elastomeric materials in an effort to minimize the shock and vibration imparted to the downhole component. One conventional design of a housing for acoustic transducers includes sealing the transducer from the external environment using molded rubber surrounding the transducer. One such example of this housing is found in U.S. Pat. No. 7,364,007, which is incorporated herein by reference and discusses transducers, sealed in a material such as molded rubber encasing the transducer and electronics. Similarly, U.S. Pat. No. 7,460,435, which is incorporated herein by reference, discusses acoustic sources for downhole use that are encased in a liquid-free sealing material, such as molded rubber for protection.

There have also been attempts to use paired mating side and connecting side materials surrounding the downhole tool, as in U.S. Pat. App. No. 2005/0263668. Each of these methods can amplify the effects of shock induced vibration instead of minimizing the effects. Encasing electronics such as printed circuit boards in molded rubber, for instance, can also create difficulties repairing the printed circuit boards if a component is damaged. Additionally manufacturing issues can arise due to high temperatures and/or pressures that may be part of the manufacturing process. Paired mating side and connecting side materials may separate from each other due to the shock to which the downhole tool may be exposed.

Therefore, there exists a need for a device and method of isolating downhole components of a downhole tool from the damaging and data altering effects of shock and vibration encountered during the use, handling and assembly of the downhole tool.

### BRIEF DISCLOSURE OF THE INVENTION

In one aspect, the present disclosure describes a chassis assembly for housing at least one circuit board. The chassis assembly is provided with a first chassis part, a second chassis part, and at least three shock absorbers. The first chassis part is provided with a first end and a second end, and a first external surface extending between the first end and the second end. The first chassis part is also provided with a first longitudinal axis extending from the first end to the second end.

The second chassis part is provided with a third end and a fourth end and a second external surface extending between the third end and the fourth end. The second chassis part is also provided with a second longitudinal axis extending from the third end to the fourth end. The first and second chassis parts are adapted to cooperate to secure the at least one circuit board within a boundary defined by the first and second external surfaces.

The at least three shock absorbers are positioned on the external surfaces of the first and second chassis parts. At least one shock absorber is positioned on the first external surface and extends along the first longitudinal axis between the first end and the second end. At least two shock absorbers are positioned on the second external surface and extend along the second longitudinal axis between the third end and the fourth end. The at least three shock absorbers extend beyond the first and second external surfaces.

In another aspect, the present disclosure describes a downhole electronic equipment for use within a well. The downhole electronic equipment is provided with a housing, a chassis assembly, and a circuit board. The housing defines a bore. The chassis assembly is positioned within the bore and is provided with a first chassis part, a second chassis part, and at least three shock absorbers. The first chassis is provided with a first end and a second end, and a first external surface extending between the first end and the second end. The first chassis part is also provided with a first longitudinal axis extending from the first end to the second end.

The second chassis part is provided with a third end and a fourth end and a second external surface extending between the third end and the fourth end. The second chassis part is also provided with a second longitudinal axis extending from the third end to the fourth end. The first and second chassis parts are adapted to cooperate to secure the at least one circuit board within a boundary defined by the first and second external surfaces. The circuit board is positioned within the inner space of the boundary defined by the first and second external surfaces of the first chassis part and the second chassis part.

The at least three shock absorbers are positioned on the external surfaces of the first and second chassis parts. At least one shock absorber is positioned on the first external surface and extends along the first longitudinal axis between the first end and the second end. At least two shock absorbers are positioned on the second external surface and extend along the second longitudinal axis between the third end and the fourth end. The at least three shock absorbers extend beyond the first and second external surfaces.

In yet another aspect, the present disclosure describes a method for making a chassis assembly for use within a wellbore, comprising the steps of providing a chassis and attaching at least three shock absorbers to the outer surface of the chassis. The chassis is provided with a first end, a second end, an outer surface and a longitudinal axis extending from the first end to the second end. Once attached, the at least three shock absorbers extend along the longitudinal axis between the first end and the second end, and extend beyond the outer surface of the chassis.

In yet another aspect, the present disclosure describes a method for making a downhole electronic equipment for use within a well comprising the steps of providing a housing defining a bore, positioning a chassis assembly within the bore, and mounting a printed circuit board within the inner space of the chassis. The chassis assembly is provided with a first end, a second end, an inner space, an outer surface, and a longitudinal axis extending from the first end to the second end, and at least three shock absorbers attached to the outer surface of the chassis. The at least three shock absorbers extend along the longitudinal axis between the first end and the second end and extend beyond the outer surface of the chassis assembly.

### BRIEF DESCRIPTION OF THE DRAWINGS

Figure 1 shows a schematic view of a testing installation;

Figure 2 shows a cross-sectional diagram of a chassis assembly constructed in accordance with the present disclosure;

Figure 3 shows another cross-sectional diagram of the chassis assembly depicted in Figure 2;

Figure 4 shows a perspective view of a chassis part depicted in Figure 2;

Figure 5 shows another perspective view of a chassis part depicted in Figure 2;

Figure 6 shows a cross-sectional diagram of a shock absorber constructed in accordance with the present disclosure;

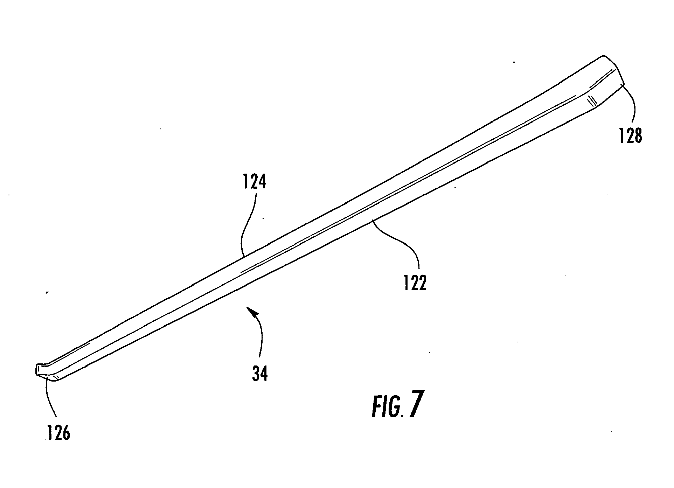

Figure 7 shows a perspective view of the shock absorber depicted in Figure 6.

### DETAILED DESCRIPTION ,

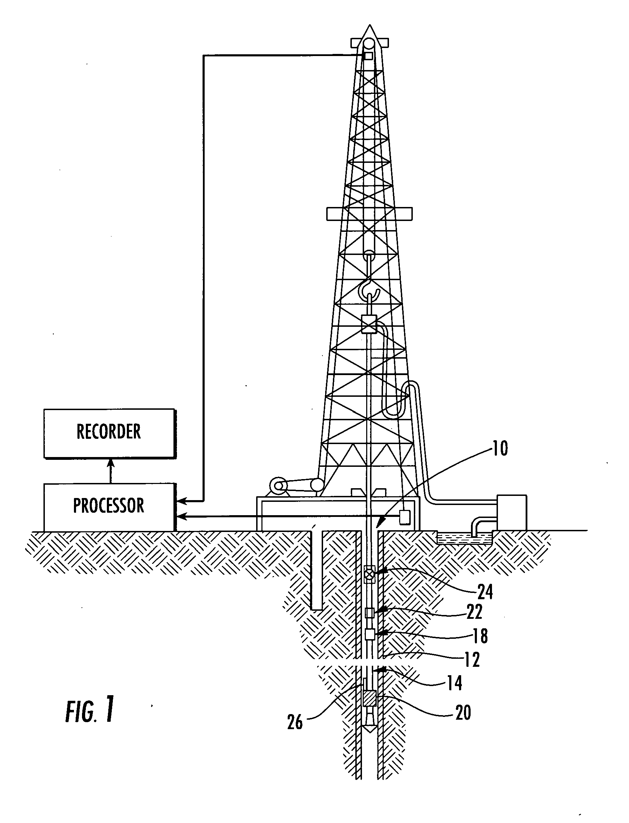

The present invention is particularly applicable to testing installations such as are used in oil and gas wells or the like. Figure 1 shows a schematic view of such a system. Once a well 10 has been drilled through a formation, a drill string can be used to perform tests, and determine various properties of the formation through which the well has been drilled. In the example of Figure 1, the well 10 has been lined with a steel casing 12 (cased hole) in the conventional manner, although similar systems can be used in unlined (open hole) environments. In order to test the formations, it is preferable to place testing apparatus in the well close to the regions to be tested, to be able to isolate sections or intervals of the well, and to convey fluids from the regions of interest to the surface. This is commonly done using a jointed tubular drill pipe, drill string, production tubing, sections thereof, or the like (collectively, tubing 14) which extends from well head equipment 16 and can include blow-out preventers and connections for fluid, power and data communication.

A packer 18 is positioned on the tubing 14 and can be actuated to seal the borehole around the tubing 14 at the region of interest. Various pieces of downhole test equipment (collectively, downhole electronic equipment 20) are connected to the tubing 14 above or below the packer 18. Such downhole electronic equipment 20 may be referred to herein as one or more downhole tool and may include, but is not limited to: additional packers; tester valves; circulation valves; downhole chokes, firing heads; TCP (tubing conveyed perforator) gun drop subs; samplers; pressure gauges; downhole flow meters; downhole fluid analyzers; and the like.

In the embodiment of Figure 1, a sampler 22 is located above the packer 18 and a tester valve 24 is located above the packer 18. The downhole electronic equipment 20 may be connected to an acoustic modem 26 which operates to allow electrical signals from the downhole electronic equipment 20 to be converted into acoustic signals for transmission to the surface via the tubing 14, and to convert acoustic tool control signals from the surface into electrical signals for operating the downhole electronic equipment 20. The term "data," as used herein, is meant to encompass control signals, tool status, and any variation thereof whether transmitted via digital or analog signals. The downhole electronic equipment 20 can be connected to the tubing 14 via any suitable manner, such as a clamp, a gauge carrier, a mandrel or the like.

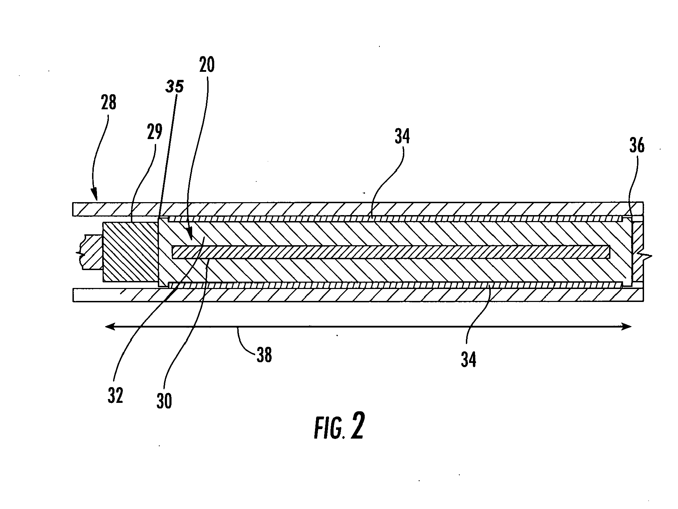

An example of the downhole electronic equipment 20 is shown in Figure 2. The downhole electronic equipment 20 includes a housing 28, having a bore 29, a printed circuit board 30 (shown in phantom) and a chassis assembly 32. The printed circuit board 30 can support one or more devices for measuring characteristics of the tubing 14, surrounding environment and drill bit, for example. The downhole electronic equipment 20 may preferably further include an apparatus (not shown) for generating electrical power for the downhole system. This typically includes one or more batteries. The housing 28 preferably has a tubular configuration, and can be constructed of one part, or multiple parts that are connected together.

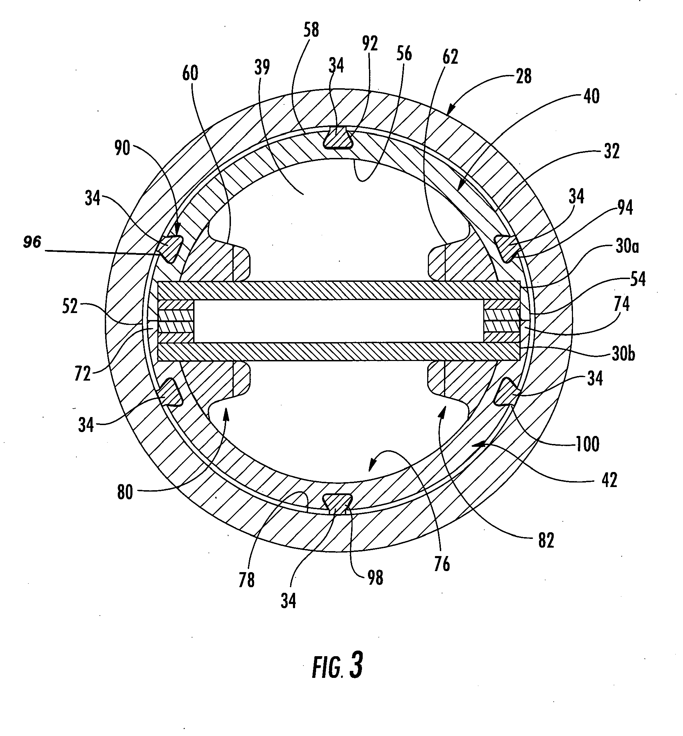

Referring now to Figure 3, shown therein is a cross-sectional diagram of the housing 28 showing the chassis assembly 32. The chassis assembly 32 is positioned within the housing 28. The chassis assembly 32 is provided with a chassis 33 and a plurality of shock absorbers 34 engaging the housing 28 and the chassis 33. Six shock absorbers 34 are shown in Figure 3 although more or fewer shock absorbers 34 can be used. The chassis assembly 32 serves to secure one or more printed circuit board 30 within the housing 28 which may be positioned within or between sections of tubing 14. The chassis 33 includes a first end 35, a second end 36, an outer surface 37 and a longitudinal axis 38 extending from the first end 35 to the second end 36. The chassis 33 also includes an inner space 39 to receive the printed circuit boards 30a and 30b, for example. The longitudinal axis 38 is shown offset from the chassis 33 for purposes of clarity.

Referring now to Figures 3, 4, and 5, shown therein is an exemplary chassis assembly 32. The chassis 33 of the chassis assembly 32 is provided with a first chassis part 40 and a second chassis part 42. The first chassis part 40 and the second chassis part 42 are connected together to secure the one or more printed circuit board 30. In this exemplary embodiment, the chassis 33 secures two printed circuit boards 30a and 30b, encased within the first chassis part 40 and the second chassis part 42. The first chassis part 40 and the second chassis part 42 may be fabricated from aluminum, steel, plastic, or any suitable material. In the preferred embodiment, but not by way of limitation, the first chassis part 40 and the second chassis part 42 are constructed from aluminum to maintain rigidity with a light weight material; however it may be beneficial to construct the first chassis part 40 and the second chassis part 42 from steel for higher temperature applications or to maintain rigidity for a longer printed circuit board 30. When composed of steel or aluminum, the first chassis part 40 and the second chassis part 42 may be constructed using forging, extrusion, or any suitable process. When composed of plastic or similar material, the first chassis part 40 and the second chassis part 42 may be constructed using a molding process. Preferably, the first chassis part 40 and the second chassis part 42 have a substantially semi-cylindrical shape as shown in Figure 3 to form a cylindrical shape when combined. The chassis 33 may be formed of a single tubular chassis part having at least one open end to receive the one or more printed circuit boards 30a and 30b. Alternatively, the chassis 33 may include more than two chassis parts.

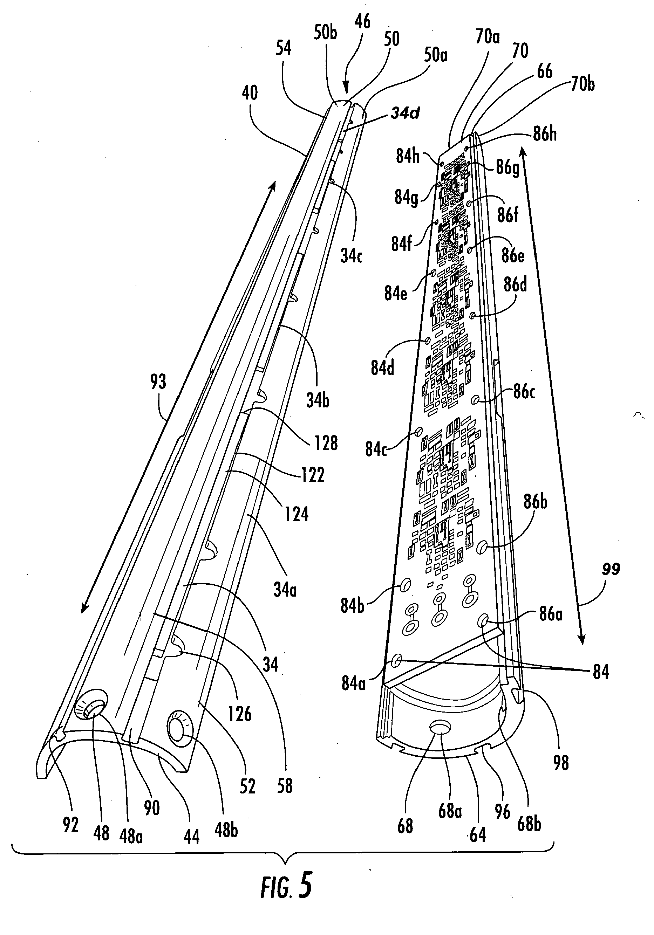

In this embodiment, the chassis 33 secures the at least two printed circuit boards 30a and 30b by placing the printed circuit boards 30a and 30b between the first chassis part 40 and the second chassis part 42 and then fastening the first chassis part 40 and the second chassis part 42 together with fasteners (not shown). The first chassis part 40 is provided with a first end 44 and a second end 46. The first chassis part 40 is provided with at least one hole 48 located substantially adjacent to the first end 44. The at least one hole 48 should preferably be capable of receiving and securing a fastener. In one preferred embodiment, the at least one hole 48 is threaded to accept a threaded fastener such as a screw, but it should be understood that any suitable fastener may be used. In the preferred embodiment shown in Figure 5, the first chassis part 40 is provided with two holes 48a and 48b substantially adjacent to the first end 44. The first chassis part 40 may also be provided with at least one hole 50 located substantially adjacent to the second end 46, capable of receiving and securing a fastener. In one preferred embodiment, the hole 50 may be threaded to accept a threaded fastener such as a screw, but it should be understood that any suitable fastener may be used. In the preferred embodiment shown in Figure 5, the first chassis part 40 is provided with two holes 50a and 50b substantially adjacent to the second end 46.

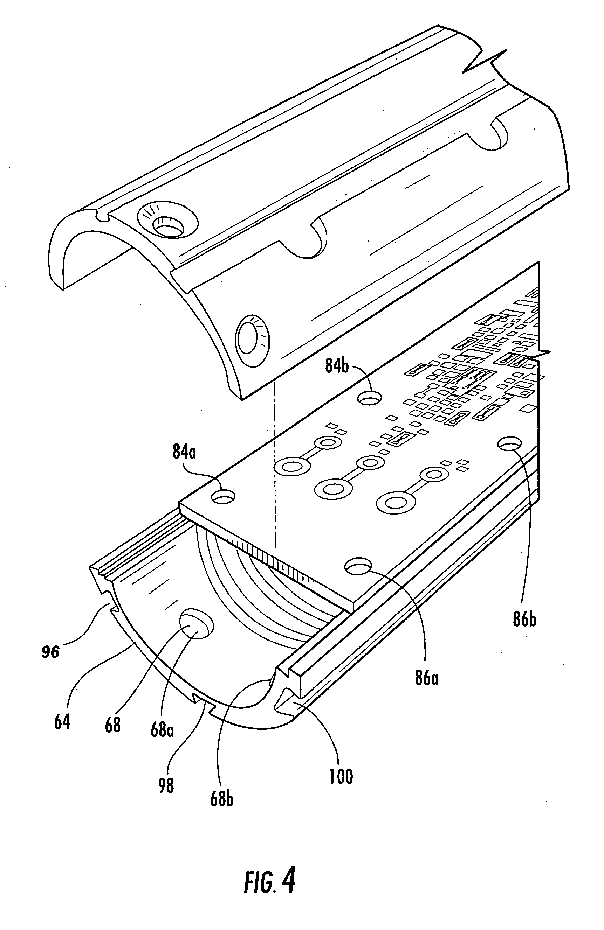

The first chassis part 40 is provided with a first side 52 and a second side 54 which extend between the first end 44 and the second end 46, as depicted in Figure 4. The first chassis part 40 is also provided with a first inner surface 56 which extends laterally between the first side 52 and the second side 54 and extends longitudinally between the first end 44 and the second end 46. The first chassis part 40 is also provided with a first external surface 58 which extends laterally between the first side 52 and the second side 54 and extends longitudinally between the first end 44 and the second end 46. The term "extend(s) longitudinally" as used herein refers to extending along the longitudinal axis 38 shown in Figure 2 when the first and/or second chassis parts 40 and 42 are assembled.

Returning now to Figure 3, the first chassis part 40 is provided with a first ledge 60 and a second ledge 62 substantially adjacent to the first side 52 and second side 54, running longitudinally between the first end 44 and the second end 46. The first ledge 60 and the second ledge 62 may span the full longitudinal distance between the first end 44 and the second end 46, or, as depicted in the preferred embodiment in Figure 4, may terminate adjacent to the first end 44 and the second end 46. It should also be understood that the first ledge 60 and the second ledge 62 may be contiguous across the full longitudinal span between the first end 44 and the second end 46, or may be separated into first and second ledge sections.

Referring now to Figure 5, the second chassis part 42 is provided with a third end 64 and a fourth end 66. The second chassis part 42 is provided with at least one hole 68 located substantially adjacent to the third end 64. The at least one hole 68 should preferably be capable of receiving and securing a fastener. In one preferred embodiment, the at least one hole 68 is threaded to accept a threaded fastener such as a screw, but it should be understood that any suitable fastener may be used. In the preferred embodiment shown in Figure 5, the second chassis part 42 is provided with two holes 68a and 68b substantially adjacent to the third end 64. The second chassis part 42 may also be provided with at least one hole 70 located substantially adjacent to the fourth end 66, capable of receiving and securing a fastener. In one preferred embodiment, the at least one hole 70 may be threaded to accept a threaded fastener such as a screw, but it should be understood that any suitable fastener may be used. In the preferred embodiment shown in Figure 5, the second chassis part 42 is provided with two holes 70a and 70b substantially adjacent to the fourth end 66.

The second chassis part 42 is provided with a third side 72 and a fourth side 74 which extend between the third end 64 and the fourth end 66, as depicted in Figure 4. The second chassis part 42 is also provided with a second inner surface 76 which extends laterally between the third side 72 and the fourth side 74 and extends longitudinally between the third end 64 and the fourth end 66. The second chassis part 42 is also provided with a second external surface 78 which extends laterally between the third side 72 and the fourth side 74 and extends longitudinally between the third end 64 and the fourth end 66.

Referring now to Figure 3, the second chassis part 42 is provided with a third ledge 80 and a fourth ledge 82 substantially adjacent to the third side 72 and fourth side 74, running longitudinally between the third end 64 and the fourth end 66. The third ledge 80 and the fourth ledge 82 may span the full longitudinal distance between the third end 64 and the fourth end 66, or, as depicted in the preferred embodiment in Figure 4, may terminate adjacent to the third end 64 and the fourth end 66. It should also be understood that the third ledge 80 and fourth ledge 82 may be contiguous across the full longitudinal span between the third end 64 and the fourth end 66, or may be separated into third and fourth ledge sections.

Referring now to Figure 5, the first ledge 60, second ledge 62, third ledge 80, and fourth ledge 82 may be of appropriate dimensions to receive fasteners (not shown) for securing the printed circuit board 30. It should be understood that the fasteners used for securing the printed circuit board 30 to the first ledge 60 and second ledge 62 or third ledge 80 and fourth ledge 82 may be a screw, bolt, or any suitable fastener. In order to receive the fasteners, the first ledge 60, second ledge 62, third ledge 80 and fourth ledge 82 may each be provided with at least two holes 84. In the preferred embodiment depicted in Figure 5, but not by way of limitation, the printed circuit board 30 and third ledge 80 are provided with holes 84a-h and the printed circuit boards 30a and 30b and fourth ledge 82 are provided with holes 86a-h. The corresponding holes for the first ledge 60 and the second ledge 62 are not shown.

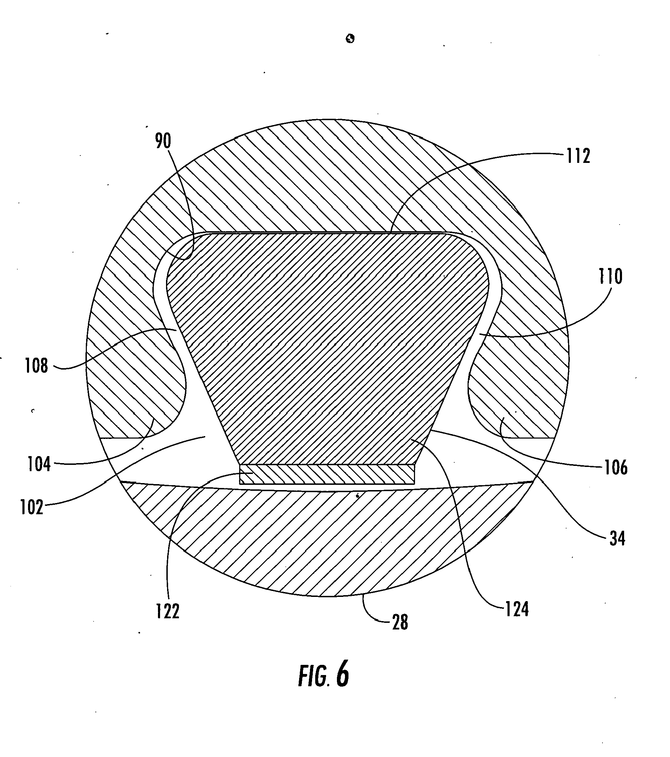

Referring now to Figure 5, the first external surface 58 is provided with at least two longitudinal slots 90 and 92. The at least two longitudinal slots 90 and 92 extending longitudinally between the first end 44 and the second end 46 along a first longitudinal axis 93. In the example shown, the second external surface 78 is provided with at least two longitudinal slots 96 and 98 extending longitudinally between the third end 64 and the fourth end 66 along a second longitudinal axis 99. In one preferred embodiment (not shown), but not by way of limitation, the chassis assembly 32, after combining the first chassis part 40 and the second chassis part 42, is provided with five longitudinal slots arranged 65° apart. In the preferred embodiment depicted in Figure 3, but not by way of limitation, the first chassis part 40 is provided with three longitudinal slots 90, 92, and 94, and the second chassis part 42 is provided with three longitudinal slots 96, 98, and 100. The longitudinal slots 90, 92, 94, 96, 98, and 100 can be formed using an extrusion process, cutting, forging, or any appropriate process. In one embodiment, the longitudinal slots 90, 92, 94, 96, 98 and 100 are identical in construction. Shown in Figure 6 is an exemplary longitudinal slot 90. In the preferred embodiment depicted in Figure 6, but not by way of limitation, the representational longitudinal slot is formed with a narrow inlet 102. Forming the narrow inlet 102 are a first rim part 104 and a second rim part 106. The first rim part 104 and second rim part 106 comprise the lateral boundaries of the narrow inlet 102, creating a first overhang 108 and a second overhang 110. The first overhang 108 and second overhang 110 form the lateral boundaries for the slot base 112. In the preferred embodiment depicted in Figure 6, but not by way of limitation, the slot base 112 has a wider lateral cross section than the narrow inlet 102.

The shock absorbers 34 are preferably identical in construction and function. The shock absorber 34 may be provided with a friction facing 122 and a deformable elastomeric absorber 124. The friction facing 122 and deformable elastomeric absorber 124 may be connected with an adhesive, cohesive, or any other suitable method. The shock absorbers 34 are placed within the longitudinal slots 90, 92, 94, 96, 98, and 100. Once placed, the shock absorber 34 serves as a spring to aid in centering the chassis assembly 32 within the housing 28 and to dampen shock to the printed circuit boards 30a and 30b. The shock absorber 34 distributes the suspended masses, such as the printed circuit board 30, in order to improve the reliability of components placed within the chassis assembly 32. The friction facing 122 may be composed of Bronze, Beryllium, Bronze and Beryllium alloy, plastic, or any other suitable material. In one preferred embodiment, but not by way of limitation, the friction facing 122 is composed of Bronze or Beryllium due to the common characteristic of suitable adherence to common deformable elastomeric materials such as silicon. The friction facing 122 is optional, but facilitates gliding during insertion of the chassis assembly 32 into the housing 28. The term "gliding" refers to movement in a smooth, preferably effortless manner. The deformable elastomeric absorber 124 may be composed of silicon, rubber, or any other suitable elastomeric material. In one preferred embodiment, but not by way of limitation, the deformable elastomeric absorber is composed of silicon due to positive elastic properties and a resistance to temperatures in excess of 200° C. In addition, silicon presents positive dampening characteristics at temperature ranges between -50° and +200° C, which are suitable to use in the deformable elastomeric absorber 124.

Returning to Figure 5, one preferred embodiment is shown in which shock absorber 34 may be comprised of a plurality of segments 125a-d. As shown in Figure 5, each of the segments 125a-d is a separate part of the shock absorber 34. The segments 125a-d may or may not be linear and may or may not be arranged in a straight line. As shown in the embodiment in Figure 5, but not by way of limitation, shock absorber 34 is constructed of four segments 124a-d contiguously arranged within the longitudinal slot 90 along the longitudinal axis 38 of the chassis 33. The segments 125a-d comprising shock absorber 34, in this embodiment, are identical to each other in construction and function, and to avoid confusion, only one has been labeled. Segments 125a-d may be provided with the friction facing 122 and the deformable elastomeric absorber 124. Segments 125a-d have a first end 126 and a second end 128. The first end 126 and second end 128 of segments 34a-d may be tapered to prevent snagging and for ease of insertion into longitudinal slot 90. Once placed, the segments 125a-d cooperate to serve as a spring to aid in centering the chassis assembly 32 within the housing 28 and dampen shock to the printed circuit boards 30a and 30b. In this embodiment, once placed, the segments 125a-d may be secured in the longitudinal slot 90 by screw or any other appropriate means to prevent slipping within the longitudinal slot 90.

To make the chassis assembly 32, the chassis 33 is provided, e.g., made available via manufacturing, purchase or the like to be assembled with the shock absorbers 34, the printed circuit boards 30a and 30b and the housing 28 as discussed herein. At least three shock absorbers 34 are attached to the outer surface 37 of the chassis 33 as shown in Figures 2-5. The shock absorbers 34 preferably extend along the longitudinal axis 38 between the first end 35 and the second end 36 and extend beyond the outer surface 37.

To make the downhole electronic equipment 20 for use within the well 10, the housing 28 is provided. The housing 28 defines the bore 29 as discussed above. The chassis assembly 32 is positioned within the bore 29. The chassis assembly 32, as discussed above, includes the chassis 33 having the first end 35, the second end 36, the inner space 39, the outer surface 37 and the longitudinal axis 38 extending from the first end 35 to the second end 36, and with at least three shock absorbers 34 attached to the outer surface 37 of the chassis 33 and extending along the longitudinal axis 38. The at least three shock absorbers 34 extend beyond the outer surface 37, and at least one of the printed circuit board 30a and/or 30b are mounted within the inner space 39 of the chassis 33.

Although only a few embodiments of the present invention have been described in detail above, those of ordinary skill in the art will readily appreciate that many modifications are possible without materially departing from the teachings of the present invention. Accordingly, such modifications are intended to be included within the scope of the present invention as defined in the claims.

## Claims

1. A chassis assembly for housing at least one circuit board, the chassis assembly comprising:
a first chassis part having a first end and a second end, and a first external surface extending between the first end and the second end, the first chassis part having a first longitudinal axis extending from the first end to the second end;
a second chassis part having a third end and a fourth end and a second external surface extending between the third end and the fourth end, the second chassis part having a second longitudinal axis extending from the third end to the fourth end, the first and second chassis parts adapted to cooperate to secure the at least one circuit board within a boundary defined by the first and second external surfaces; and
at least three shock absorbers, with at least one shock absorber positioned on the first external surface and extending along the first longitudinal axis between the first end and the second end, and at least two shock absorbers positioned on the second external surface and extending along the second longitudinal axis between the third end and the fourth end, the at least three shock absorbers extending beyond the first and second external surfaces.

2. The chassis assembly of claim 1, wherein the first external surface contains at least one slot extending between the first end and the second end along the first longitudinal axis, and wherein the at least one shock absorber is positioned within the slot.

3. The chassis assembly of claim 1, wherein the at least one shock absorber comprises spatially disposed shock absorber sections.

4. The chassis assembly of claim 2, wherein the at least one slot is a linear slot.

5. The chassis assembly of claim 1, wherein the second external surface contains at least two slots extending between the third end and the fourth end along the second longitudinal axis and wherein the at least two shock absorbers are positioned within the at least two slots.

6. The chassis assembly of claim 5, wherein the at least two shock absorbers comprise spatially disposed shock absorber sections.

7. The chassis assembly of claim 5, wherein the at least two slots are linear slots.

8. The chassis assembly of claim 1, wherein the shock absorbers comprise an elastometic absorber and a friction facing with the friction facing extending beyond the first and second external surfaces.

9. A downhole electronic equipment for use within a well, comprising:
a housing defining a bore;
a chassis assembly positioned within the bore; the chassis assembly including:
a first chassis part having a first end and a second end, and a first external surface extending between the first end and the second end, the first chassis part having a first longitudinal axis extending from the first end to the second end;
a second chassis part having a third end and a fourth end and a second external surface extending between the third end and the fourth end, the second chassis part having a second longitudinal axis extending from the third end to the fourth end, the first and second chassis parts adapted to cooperate to secure at least one circuit board within a boundary defined by the first and second external surfaces; and
at least three shock absorbers, with at least one shock absorber positioned on the first external surface and extending along the first longitudinal axis between the first end and the second end, and at least two shock absorbers positioned on the second external surface and extending along the second longitudinal axis between the third end and the fourth end, the at least three shock absorbers extending beyond the first and second external surfaces; and
a circuit board mounted within the inner space of the boundary defined by the first and second external surfaces of the first chassis part and the second chassis part.

10. The downhole electronic equipment of claim 9, wherein the carrier has a cylindrical shape.

11. The downhole electronic equipment of claim 9, wherein a plurality of slots are formed in the external surface of the carrier.

12. A method of making a chassis assembly for use within a wellbore comprising the steps of:
providing a chassis having a first end, a second end, an outer surface and a longitudinal axis extending from the first end to the second end; and
attaching at least three shock absorbers to the outer surface of the chassis and extending along the longitudinal axis between the first end and the second end, the at least three shock absorbers extending beyond the outer surface.

13. A method of making a downhole electronic equipment for use within a well comprising the steps of:
providing a housing defining a bore; and
positioning a chassis assembly within the bore, the chassis assembly including a chassis having a first end, a second end, an inner space, an outer surface and a longitudinal axis extending from the first end to the second end, at least three shock absorbers attached to the outer surface of the chassis and extending along the longitudinal axis between the first end and the second end, the at least three shock absorbers extending beyond the outer surface, and a printed circuit board mounted within the inner space of the chassis.
